**Europäisches Patentamt**

**European Patent Office**

**Office européen des brevets**

(19)

(11) Publication number: **0 092 925**

**A1**

(12) # EUROPEAN PATENT APPLICATION

(21) Application number: **83301973.0**

(22) Date of filing: **07.04.83**

(51) Int. Cl.³: **H 01 L 31/06**
**H 01 L 31/18**

(30) Priority: **12.04.82 US 367812**

(43) Date of publication of application:
**02.11.83 Bulletin 83/44**

(84) Designated Contracting States:
**DE FR GB**

(71) Applicant: CHEVRON RESEARCH COMPANY
525 Market Street
San Francisco California 94120(US)

(72) Inventor: Madan, Arun
21830 Cabrini Boulevard
Look Out Mountain Golden, Col. 80401(US)

(74) Representative: Kosmin, Gerald Emmanuel et al,
HASELTINE, LAKE & CO. Hazlitt House 28 Southampton
Buildings Chancery Lane
London, WC2A 1AT(GB)

(54) Solar cell incorporating a photoactive compensated intrinsic amorphous silicon layer and an insulating layer and method of fabrication thereof.

(57) An amorphous silicon solar cell which minimizes back diffusion of holes into an N-type layer of hydrogenated amorphous silicon incident to solar radiation and which has a photoactive intrinsic layer matched more closely to the ideal bandgap for increased absorption of solar radiation is characterised by having a photoactive compensated intrinsic hydrogenated amorphous silicon layer (16) incorporating N-type and P-type dopants in an amount sufficient to reduce the bandgap of the layer, preferably to below about 1.6 eV, while maintaining a recombination lifetime of holes and electrons which is greater than their transit time out of the layer during solar illumination, and by having an insulating layer (18) between said layer (16) and the incident N-type layer (20). Fabrication of the solar cell is advantageously effected in a glow discharge apparatus.

FIG.__1.

Solar cell incorporating a photoactive compensated intrinsic amorphous silicon layer and an insulating layer and method of fabrication thereof

This invention relates to thin film solar cells and is concerned with thin film hydrogenated amorphous silicon solar cells.

Photovoltaic cells, such as hydrogenated amorphous silicon solar cells, are capable of converting solar radiation into usable electrical energy. The electrical energy conversion occurs as a result of what is well known in the solar cell field as the photovoltaic effect. Solar radiation impinging on a solar cell is absorbed by the semiconductor layer which generates electrons and holes. The electrons and holes are separated by a built-in electric field, for example, a rectifying junction such as an N-I-P junction in the solar cell. The electrons flow towards the N-type region and the holes flow towards the P-type region. The separation of the holes and electrons across the rectifying junction results in the generation of an electric current known as the photocurrent and an electric voltage known as the photovoltage.

Photovoltaic researchers have been investigating various paths towards the generation of electricity from sunlight which can compete on an economic basis with conventional means of generating electricity. One of the main areas of focus for research is low cost, large area hydrogenated amorphous silicon solar cells. Hydrogenated amorphous silicon is a low cost semiconductor material which can be manufactured by processes such as glow discharge, sputtering, or reactive sputter deposition. These processes are adaptable to automated manufacturing techniques and large area panels. Current research focuses on improving the efficiency of the devices as the area of the cells increases. The cells can be fabricated in many known semiconductor configurations, such as P-I-N solar cells, N-I-P solar cells, Schottky barrier solar cells and MIS solar cells. The first letter designates the incident surface through which solar radiation first penetrates the cell.

Hitherto, devices incorporating a photoactive intrinsic region, such as N-I-P devices, have exhibited the highest efficiences. However, G.A. Swartz teaches, in J. Appl. Phys. $\underline{53}$,712 (1982), that a limiting factor in an N-I-P solar cell is the back diffusion of holes into the N-type layer which lowers the short circuit current ($J_{sc}$) of the device. In addition, the photoactive intrinsic region of the N-I-P device has a bandgap greater than the optimum bandgap for the maximum absorption of solar radiation.

It is therefore an object of the present invention to provide an N-I-P solar cell wherein solar radiation enters through the N-type region, which minimizes the back diffusion of holes and has a photoactive intrinsic region more closely matched to the ideal bandgap for increased absorption of solar radiation.

Thus in accordance with one aspect of the invention, there is provided a solar cell comprising:

a layer of P-type conductivity hydrogenated amorphous silicon;

a layer of photoactive compensated intrinsic hydrogenated amorphous silicon contacting said P-type layer, said layer incorporating N-type and P-type dopants in an amount sufficient to reduce the bandgap of the layer while maintaining a recombination lifetime which is greater than the transit time of holes and electrons out of said layer during the illumination of said layer by solar radiation;

a layer of electrically insulating material contiguous to and contacting said layer of photoactive compensated intrinsic hydrogenated amorphous silicon;

an incident layer of N-type conductivity hydrogenated amorphous silicon contacting said insulating layer;

means for electrically contacting said N-type layer; and

a substrate layer supporting said other layers.

In accordance with another aspect of the invention, there is provided a method of reflecting holes back into a photoactive compensated intrinsic hydrogenated amorphous silicon layer in an amorphous silicon solar cell, said solar cell incorporating an N-type conductivity hydrogenated amorphous silicon layer incident to solar radiation, which method comprises:

incorporating N-type and P-type dopants into the photoactive compensated intrinsic layer during the fabrication thereof in an amount sufficient to reduce the bandgap of the photoactive compensated intrinsic layer while maintaining a recombination lifetime of holes and electrons which is greater than the transit time of said holes and electrons out of said layer during the illumination of the layer by solar radiation; and

fabricating an insulating layer between the photoactive compensated intrinsic layer and the N-type layer.

For a better understandng of the invention and to show how the same may be carried into effect, reference will now be made, by way of example, to the accompanying drawing, in which:

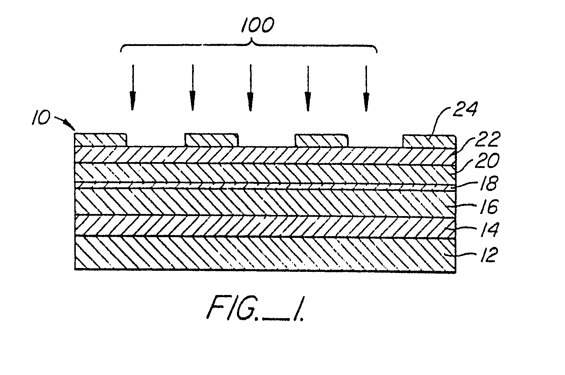

Figure 1 is a vertical cross-section of an N-I-P solar cell i corporating in accordance with the invention a photoactive compensated intrinsic amorphous silicon layer and also an insulating layer between an N-type layer of hydrogenated amorphous silicon and the said photoactive intrinsic layer.

Referring to FIG. 1, an N-I-P solar cell 10 has solar radiation 100 impinging thereon. This forms a reference point for the incident surface of each layer or region of the solar cell. The solar cell 10 includes an electrically conductive substrate 12 made of, for example, stainless steel, molybdenum, or titanium. Optionally, a thin layer of a highly reflecting metal, for example aluminium or chromium, can be deposited on the base metal substrate 12 to reflect solar radiation back into a photoactive layer 16. Alternatively, substrate 12 can be made of a transparent material, for example glass or sapphire, coated with a layer of an electrically conductive material, for example a transparent conductive oxide (hereinafter referred to as TCO), such as a tin oxide or indium tin oxide. If the substrate 12 is a transparent material coated with a TCO layer, then solar radiation can enter from a direction opposite to solar radiation 100, in which case the layers 14, 16, 18 and 20 will be reversed to form an N-I-P solar cell of the backwall construction type.

A first layer 14 of P-type hydrogenated amorphous silicon is deposited upon the substrate 12. Preferably, the layer 14 is graded from $P^+$-type conductivity ohmically contacting the substrate 12 to P-type conductivity contacting layer 16. The hydrogenated amorphous silicon may be fabricated by glow discharge, sputtering, or reactive sputtering. Glow discharge is the preferred method of fabrication. The layer 14 is doped to a P-type conductivity with P-type conductivity modifiers, for example boron, aluminium, gallium or indium. The layer 14 has a bandgap which is typically of the order of from 1.2-1.4 eV and has a thickness of from 20 to 50 nanometers, preferably about 30 nanometers. The layer 14 incorporates P-type conductivity modifiers generally in an amount of from 20 to 40,000 volume ppm and preferably about 30,000 ppm. Alternatively, the P-type layer can be a wide bandgap amorphous silicon, i.e. greater than 1.8 eV, if the amorphous silicon is fabricated in an atmosphere which includes $NH_3$, $N_2O$ or $CH_4$.

A layer 16 of photoactive compensated intrinsic amorphous silicon is deposited upon layer 14. The photoactive compensated intrinsic layer is generally from 250 to 400 nanometers thick, preferably about 350 nanometers thick. The layer 16 has a bandgap of not more than 1.6 eV and is generally in the range from 1.4 to 1.6 eV, preferably about 1.5 eV. The photoactive layer 16 would have a bandgap in excess of about 1.7 eV if it were not compensated. The increased absorption of the compensated region permits the thickness of the layer to be reduced. An uncompensated layer is typically of the order of 400-1000 nanometers thick. The N-type and P-type dopants are incorporated into the layer 16 in a concentration which is generally from 500 to 1500 volume ppm. The concentration of the dopants is adjusted to decrease the bandgap of the photoactive intrinsic region and thus increase the absorption. Since the incorporation of the dopants tends to increase the defect state density, the concentration of the dopants should be adjusted so that the recombination lifetime of photogenerated electrons and holes is greater than the transit time for holes and electrons to migrate toward the N-type and P-type regions, respectively.

The P-type dopants are added to reduce the optical bandgap to the desired bandgap energy, preferably about 1.5 eV. However, the P-type dopants lower the Fermi level of the material below that of uncompensated photoactive intrinsic hydrogenated amorphous silicon. Therefore, sufficient N-type dopants are also added to bring the Fermi level of the intrinsic hydrogenated silicon back up to the level of uncompensated hydrogenated amorphous silicon. Preferably, the level of N-type dopants is adjusted so that the final solar cell has a Fermi level that moves through the lowest possible density of states such as to give the widest possible depletion width for the compensated intrinsic material contacing either a Schottky barrier metal or a different doped semiconductor material such as P-type a-Si:H or P-type a-Si:F:H. The amount of N-type dopants added is generally such as to maximize the photoluminescence of the hydrogenated amorphous silicon whilst providing a conductivity activation energy of 0.6 eV to 0.8 eV, preferably about 0.7 eV.

Between the photoactive compensated intrinsic layer 16 and an N-type layer 20 of the solar cell is a thin insulating layer 18. The insulating layer 18 generally has a thickness of from 1 to 5 nanometers, preferably about 3 nanometers. Suitable insulators for forming the layer 18 are, for example, silicon nitride ($Si_3N_4$), $SiO_2$, BN, $Ta_2O_5$ and $Nb_2O_5$. $Si_3N_4$ and $SiO_2$ are preferred because the materials can be fabricated in a glow discharge atmosphere with silane and ammonia, or silane and nitrous oxide ($N_2O$), respectively. The incorporation of the insulating layer 18 between the photoactive compensated intrinsic layer 16 and the N-type layer 20 serves to reflect holes back into the photoactive compensated intrinsic layer 16. The reflection of the holes prevents them from combining with electrons in the N-type layer 20 which would thus reduce the $J_{sc}$ of the solar cell 10.

The insulating layer 18 is selected and/or adjusted so that the electron affinity of the insulator is the same as the semiconductor material and there is no impediment to the electric current flow. However, this insulating layer presents a barrier to the back diffusion of holes because of the wider bandgap energy of the insulator in comparison to the bandgap energy of the semiconductor. This suppression of the back diffusion of holes increases the quantum efficiency of the solar cell in the blue region of the solar spectrum. The thickness of the insulating layer is adjusted to maximize the quantum efficiency at the blue end of the AM 1 excitation spectrum. Beyond this thickness, the overall quantum efficiency of the solar cell is decreased because the solar cell operates in tunnel dominated regime rather than a semiconductor dominated regime.

A layer 20 of N-type hydrogenated amorphous silicon is fabricated on top of the insulating layer 18. Preferably, layer 20 is graded from N-type conductivity at the layer 18 interface to $N^+$-type conductivity at the layer 22 interface. The $N^+$-type conductivity assures an ohmic contact with layer 22. The layer 20 incorporates suitable N-type dopants, for example phosphorus, arsenic, nitrogen or antimony. Phosphorus is a preferred dopant because it can be incorporated during the glow discharge fabrication of the layer by means of the use of phosphine gas ($PH_3$). The layer 20 generally has a thickness of from 10 to 40 nanometers, preferably 20 to 30 nanometers, with an N-type dopant concentration of about 10,000 volume ppm and a bandgap of about 1.8 eV.

A transparent conductive electrode (hereinafter referred to as TCE) layer 22 is fabricated on the layer 20. The TCE layer may be fabricated in a quarter wavelength thickness to possess antireflection properties and increase the overall efficiency of the solar cell. A suitable TCE layer can be formed from a transparent conductive oxide for example indium tin oxide. The TCE layer 22 can generally have a thickness of from 50 to 150 nanometers, preferably about 70 nanometers. The TCE layer should have a sheet resistivity of less than about 60 ohms/square, preferably less than about 30 ohms/square and most preferably less than about 20 ohms/square. Optionally, TCE layer 22 can be a layer of thin transparent metal, for example gold or platinum.

As the size of the solar cell 10 increases, a grid electrode 24 must be fabricated on the TCE layer 22 to withdraw the current from the solar cell generated during illumination by solar radiation illustrated as 100.

Optionally, the cell can be fabricated in the form of a back wall construction wherein the major supporting substrate is a transparent material such as glass or sapphire and the TCE contacts the transparent substrate. In this embodiment, the back electrode 12 can be a thick film cermet as described in U.S. Patent 4,162,505.

The solar cell can be fabricated by methods known in the art, such as those described in U.S. Patents 4,064,521; 4,217,148; and 4,226,898. Suitable glow discharge apparatus is commercially available, for example a Model 2306 of Plasma Systems, Inc., a subsidiary of Plasma-Therm, Inc., Woburn, Massachusetts; a Model PWS 450 Coyote, a product of Pacific Western Systems, Inc., Mountain View, California, or a Model PND-301-MQ(6), a product of LFE Corp., Waltham, Massachusetts.

For example, P-type or $P^+$-type hydrogenated amorphous silicon can be fabricated from $SiH_4 + B_2H_6$, $SiH_4 + H_2 + B_2H_6$, $SiF_4 + H_2 + B_2H_6$, $SiCl_2H_2 + H_2 + B_2H_6$, or the halogenated silicon gases plus hydrogen and a P-type dopant. Wide bandgap P-type material can be fabricated from $SiH_4 + CH_4 + B_2H_6$, $SiH_4 + N_2O + B_2H_6$, $SiH_4 + NH_3 + B_2H_6$, or the halogenated silicon gases and $CH_4$ or $NH_3$. The compensated intrinsic amorphous silicon can be fabricated from $SiH_4 + B_2H_6 + PH_3$, $SiF_4 + H_2 + B_2H_6 + PH_3$, $SiH_4 + H_2 + B_2H_6 + PH_3$, other halogenated silicon gases, hydrogen, diborane and phosphine. N-type or $N^+$-type material can be fabricated from the same materials as the P-type material, except that $PH_3$, $AsH_3$ or other suitable N-type dopant is substituted for the P-type dopant. Suitable substrate forming temperatures are from 250-350°C with a power density of $0.2-2w/cm^2$, a flow rate of 5-50 SCCM and a deposition pressure of 0.1-2 Torr.

More specifically, a substrate is placed in a glow discharge apparatus and the pressure in the apparatus is reduced to about $10^{-6}$ Torr. Thereafter, the temperature of the substrate is raised to about 280°C and silane ($SiH_4$) at a flow rate of about 20 SCCM containing from 1 to 5% $B_2H_6$ is passed into the glow discharge apparatus whilst the background pressure is maintained at about 0.5 Torr. The glow discharge electrodes are energized and the silane containing P-type dopant flow rate is continued until a P-type layer of about 20-nanometer thickness is fabricated. Thereafter, the P-type dopant concentration is reduced to 500 - 1500 vol. ppm and an N-type doping source is turned on to grow about a 350-nanometer compensated photoactive intrinsic layer containing from 500 to 1500 volume ppm N-type and P-type dopants. At the completion of the growth of the photoactive layer, the flow of N-type and P-type dopants is terminated and ammonia is admitted into the glow discharge chamber in an amount such that the atmosphere is about 70% silane and 30% ammonia. The flow rate of the gases is about 20 SCCM. The flow rate is continued until the thin insulating layer of about 3 nanometers is deposited on the photoactive compensated intrinsic layer. At the completion of the growth of the insulating layer, the ammonia flow is terminated and silane with about 1% N-type dopant of phosphine is admitted to grow a 20 to 30 nanometers thick layer of N-type conductivity amorphous silicon. During the growth of the N-type layer, the substrate temperature is reduced to about 280°C.

Thereafter, a transparent conductive oxide layer is fabricated on top of the $N^+$-type layer by evaporation. If necessary, the grid electrode is fabricated on the transparent conductive oxide by, for example, photolithographic techniques or electron beam evaporation through a mask. Finally, wires are attached to the top electrodes and the base substrate electrode.

Although the embodiment of the invention described above is a P-type/compensated intrinsic/insulating/N-type solar cell, the invention is equally applicable to any device which incorporates a photoactive intrinsic region and an N-type region which is incident to solar radiation such as an MIS solar cell or an N-type schottky barrier solar cell. The solar cell may also be fabricated as a solar battery as disclosed in U.S. Patent 4,316,049.

CLAIMS:

1. A solar cell comprising:

a layer of P-type conductivity hydrogenated amorphous silicon;

a layer of photoactive compensated intrinsic hydrogenated amorphous silicon contacting said P-type layer, said layer incorporating N-type and P-type dopants in an amount sufficient to reduce the bandgap of the layer while maintaining a recombination lifetime which is greater than the transit time of holes and electrons out of said layer during the illumination of said layer by solar radiation;

a layer of electrically insulating material contiguous to and contacting said layer of photoactive compensated intrinsic hydrogenated amorphous silicon;

an incident layer of N-type conductivity hydrogenated amorphous silicon contacting said insulating layer;

means for electrically contacting said N-type layer; and

a substrate layer supporting said other layers.

2. A solar cell as claimed in Claim 1, wherein the insulating layer has a thickness of from 1 to 5 nanometers.

3. A solar cell as claimed in Claim 2, wherein the insulating layer has a thickness of about 3 nanometers.

4. A solar cell as claimed in Claim 1, 2 or 3, wherein the insulating layer is formed from an insulator selected from $Si_3N_4$, $SiO_2$, BN, $Ta_2O_5$ and $Nb_2O_5$.

5. A solar cell as claimed in Claim 1, 2, 3 or 4, wherein the photoactive compensated layer incorporates N-type and P-type dopants in an amount of from 500 to 1500 volume ppm.

6. A solar cell as claimed in any preceding claim, wherein the photoactive compensated layer has a bandgap of from 1.4 to 1.6 eV.

7. A solar cell as claimed in Claim 6, wherein the bandgap is about 1.5 eV.

8. A solar cell as claimed in any preceding claim, wherein the photoactive compensated layer has a thickness of from 250 to 400 nanometers.

9. A method of reflecting holes back into a photoactive compensated intrinsic hydrogenated amorphous silicon layer in an amorphous silicon solar cell, said solar cell incorporating an N-type conductivity hydrogenated amorphous silicon layer incident to solar radiation, which method comprises:

incorporating N-type and P-type dopants into the photoactive compensated intrinsic layer during the fabrication thereof in an amount sufficient to reduce the bandgap of the photoactive compensated intrinsic layer while maintaining a recombination lifetime of holes and electrons which is greater than the transit time of said holes and electrons out of said layer during the illumination of the layer by solar radiation and

fabricating an insulating layer between the photoactive compensated intrinsic layer and the N-type layer.

10. A method according to Claim 9, wherein the N-type and P-type dopants are incorporated into the photoactive compensated layer in concentrations of the order of 500 to 1500 vol. ppm.

11. A method according to Claim 9 or 10, wherein fabrication is effected in a glow discharge apparatus.

12. A method according to Claim 11, wherein the fabrication is effected at temperatures in the range from 250 to 350°C.

13. A method according to Claim 9, 10, 11 or 12, wherein the photoactive compensated layer has a bandgap energy of not more than 1.6 eV.

FIG.__1.

# EUROPEAN SEARCH REPORT

0092925

Application number

EP 83 30 1973

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| D,A | US-A-4 217 148 (D.E. CARLSON)<br><br>* Column 1, line 38 - column 5, line 21; figures 1, 2 * | 1,8,9,<br>11,12 | H 01 L 31/06<br>H 01 L 31/18 |
| A | US-A-4 272 641 (J.J. HANAK)<br>* Column 1, line 17 - column 3, line 48; figures 1, 2 * | 1 | |
| A | DE-A-2 826 752 (R.C.A.)<br>* Page 4, paragraph 3 - page 5, paragraph 3; page 6, paragraph 6 - page 10, paragraph 2; figure 1 * | 1,2,4 | |
| A | APPLIED PHYSICS LETTERS, vol. 37, no. 9, November 1980, New York A. MADAN et al. "Metal-insulator-semiconductor solar cells using amorphous Si:F:H alloys", pages 826-828<br>* Whole document * | 1,2,4,<br>8 | TECHNICAL FIELDS SEARCHED (Int. Cl. 3)<br><br>H 01 L 31/00 |
| A | JOURNAL OF APPLIED PHYSICS, vol. 52, no. 12, December 1981, New York K. SEN et al. "A new structure for a semiconductor-insulator-semiconductor solar cell", pages 7309-7312<br>* Paragraphs I, II; figure 1 * | 1,9 | |

--- -/-

The present search report has been drawn up for all claims

| Place of search<br>BERLIN | Date of completion of the search<br>01-07-1983 | Examiner<br>ROUSSEL A T |
|---|---|---|

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl. ³) |
|---|---|---|---|
| D,A | JOURNAL OF APPLIED PHYSICS, vol. 53, no. 1, Janua ry 1982, New York G.A. SWARTZ "Computer model of amorphous silicon solar cell", pages 712-719 * Paragraph VII * | 1,9 | |

TECHNICAL FIELDS
SEARCHED (Int. Cl. ³)

The present search report has been drawn up for all claims

| Place of search BERLIN | Date of completion of the search 01-07-1983 | Examiner ROUSSEL A T |
|---|---|---|